# EUROPEAN PATENT APPLICATION

(11) **EP 4 796 942 A1**
(43) Date of publication of application: **26.08.2026**
(21) Application number: 25160042.5
(22) Date of filing: 25.02.2025
(51) Int. Cl.: G01R 31/389

(54) **IMPEDANCE ESTIMATION OF A BATTERY SET OF BATTERY ENERGY STORAGE SYSTEM**

(71) Applicant: Volvo Penta Corporation, 405 08 Göteborg (SE)
(72) Inventor: KERSTEN, Anton, 433 42 Partille (SE); JARGANS, Ringolds, 462 31 Trollhättan (SE)
(74) Representative: Valea AB

(57) **Abstract**

A method, device, and system for estimating impedance of a battery set associated with a battery energy storage system (BESS) are disclosed. The method may include, and the device or system, or both, may be configured for obtaining an AC signal that comprises an odd harmonic of an operating frequency of a system coupled with the BESS, injecting the AC signal into a node of the battery set, and estimating an AC impedance of the battery set based on a response of the battery set to the injected AC signal. The injected harmonic may be a third harmonic of a system coupled with the BESS, such as a utility system.

## Description

### TECHNICAL FIELD

The disclosure relates generally to impedance estimation for batteries. In particular aspects, the disclosure relates to impedance estimation of a battery set of a battery energy storage system. The disclosure can be applied to various battery energy storage systems, such as those providing supplementary or back-up power for utility, industrial, or commercial applications. Although the disclosure may be described with respect to a particular energy storage system, the disclosure is not restricted to any particular application.

### BACKGROUND

A battery energy storage system (BESS) captures and stores electrical energy for later use. A BESS may support electric utility grid stability, renewable energy integration, and power supply reliability. Batteries or battery sets within a BESS may have certain internal characteristics that change over time due to physical, chemical, or operational aspects or conditions. Effective management of a BESS and the associated battery set depends on accurate determination and monitoring of such internal characteristics.

### SUMMARY

According to a first aspect of the disclosure, a method for estimating impedance of a battery set associated with a battery energy storage system (BESS) is provided. The method comprises obtaining an AC signal that comprises an odd harmonic of an operating frequency of a system coupled with the BESS, injecting the AC signal into a node of the battery set, and estimating an AC impedance of the battery set based on a response of the battery set to the injected AC signal. The first aspect of the disclosure may seek to determine impedance of one or more batteries of a battery set and thus determine other important battery characteristics or parameters without disrupting BESS operation. A technical benefit may include determining such battery characteristics and/or parameters (such as battery temperature, battery state of charge, state of health, and/or battery power capability) with a higher level of accuracy than other (e.g., exclusively DC-based impedance estimation) methods and in a manner that is usable with various types of sensors without disrupting BESS operations, e.g., thereby advantageously reducing a "down time" of the BESS.

The electronic device and methods disclosed herein may allow for improved efficiency of operations of the battery set, e.g., improved longevity of the battery set associated with the BESS. For example, determining battery characteristics and/or parameters with a higher level of accuracy may allow for operations (such as charging and/or discharging) of the battery set to be performed more accurately, such with an improved efficiency.

Optionally in some examples, including in at least one preferred example, the method may include injecting an AC signal that comprises a third harmonic of the operating frequency of the system coupled with the BESS. A technical benefit may include creating a response signal that provides an accurate and faster response (e.g., relative to measuring a DC response) indicative of battery internal impedance.

Optionally in some examples, including in at least one preferred example, the method may comprise estimating a DC impedance of the battery set, and determining a total estimated impedance based on the estimated AC impedance and the estimated DC impedance. A technical benefit may include a more accurate impedance estimation than relying on either an AC response or a DC response alone.

Optionally in some examples, including in at least one preferred example, the method may comprise determining, based on the AC impedance or the total estimated impedance, or both, a characteristic of the battery set, the characteristic comprising at least one of a state of charge (SoC), battery temperature, or power capability, or any combination thereof. A technical benefit may include characterizing battery set parameters, such as internal parameters, to support BESS management.

Optionally in some examples of the method, including in at least one preferred example, the operating frequency of the system coupled with the BESS may comprise 50 Hertz or 60 Hertz. A technical benefit may include integration with or compatibility with an operating frequency of a utility system, such as a utility grid operating frequency in Europe, Asia, Africa, North America, South America, or Oceania nations.

Optionally in some examples, including in at least one preferred example, estimating the AC impedance of the battery set may comprise measuring the response of the battery set at least 100 milliseconds after injecting the AC signal. A technical benefit may include analyzing a response signal at a relatively short time (e.g., relative to a DC-based estimation) while allowing the response to reach a steady state and thus support accurate measurement.

Optionally in some examples, including in at least one preferred example, the method may comprise charging or discharging, or both, the battery set using pulse width modulation (PWM) and the AC signal may be generated based on the PWM. A technical benefit may include leveraging a modulation technique that creates a suitable AC signal to support impedance estimation from an inverter of the BESS.

Optionally in some examples, including in at least one preferred example, the method may comprise estimating an impedance for each of one or more batteries of the battery set. A technical benefit may include, relative to considering the battery set as a whole, more specific data or more accurate data, or both, from which to assess the health or operation of the battery set.

Optionally in some examples, including in at least one preferred example, estimating the AC impedance may comprise performing a galvanostatic impedance estimation. A technical benefit may include capturing results under controlled conditions and irrespective of voltage variations of a battery set to improve reliability of results.

According to a second aspect of the disclosure, an electronic device operable with a BESS is provided. The electronic device may be integrated with or separate from the BESS. The electronic device comprises processing circuitry and memory circuitry, and the electronic device is configured to obtain an AC signal that comprises an odd harmonic of an operating frequency of a system coupled with the BESS, inject the AC signal into a node of the battery set, and estimate an AC impedance of the battery set based on a response of the battery set to the injected AC signal. The second aspect of the disclosure may seek to solve a similar problem as the first aspect of the disclosure through hardware that may be integrated or may be complementary to a BESS. A technical benefit may include a device, such as a standalone or integrated device, capable of determining battery characteristics or parameters with a higher level of accuracy than other devices implementing other (e.g., exclusively DC-based impedance estimation) methods and in a manner that is usable with various types of sensors without disrupting BESS operations.

Optionally in some examples, including in at least one preferred example, the electronic device may be configured to inject an AC signal that comprises a third harmonic of the operating frequency of the system coupled with the BESS. A technical benefit may include creating a response signal that provides an accurate and faster response (e.g., relative to measuring a DC response) indicative of battery internal impedance.

Optionally in some examples, including in at least one preferred example, the electronic device may be configured to estimate a DC impedance of the battery set, and determine a total estimated impedance based on the estimated AC impedance and the estimated DC impedance. A technical benefit may include a more accurate impedance estimation than relying on either an AC response or a DC response.

Optionally in some examples, including in at least one preferred example, the electronic device may be configured to determine, based on the AC impedance or the total estimated impedance, or both, a characteristic of the battery set, the characteristic comprising at least one of a state of charge (SoC), battery temperature, or power capability, or any combination thereof. A technical benefit may include characterizing battery set parameters, such as internal parameters, to support BESS management.

Optionally in some examples, including in at least one preferred example, the electronic device may be configured for compatibility with an operating frequency of the system coupled with the BESS that may comprise 50 Hertz or 60 Hertz. A technical benefit may include suitability for integration with a utility system, such as a utility grid operating frequency in Europe, Asia, Africa, North America, South America, or Oceania nations.

Optionally in some examples, including in at least one preferred example, the electronic device may be configured to measure the response of the battery set at least 100 milliseconds after injecting the AC signal, and to estimate the AC impedance of the battery set based on the response of the battery set measured at least 100 milliseconds after injecting the AC signal. A technical benefit may include analyzing a response signal at a relatively short time (e.g., relative to a DC-based estimation) while allowing the response to reach a steady state and thus support accurate measurement.

Optionally in some examples, including in at least one preferred example, the electronic device may be configured to estimate an impedance for each of one or more batteries of the battery set. A technical benefit may include capturing more specific data or more accurate data, or both, from which to assess the battery set.

Optionally in some examples, including in at least one preferred example, the electronic device may be configured to perform a galvanostatic impedance estimation, and estimate the AC impedance based on the estimated galvanostatic impedance. A technical benefit may include capturing results under controlled conditions to improve reliability of results.

Optionally in some examples, including one or more preferred examples, the electronic device may be configured to implement any of examples of the method of the first aspect of the disclosure, providing the same or similar technical benefits.

According to a third aspect of the disclosure, a BESS is provided. The BESS comprises a battery set comprising a first battery connected in series with a second battery via a node, a Neutral Point Clamped (NPC) inverter coupled with the battery set via the node, and circuitry configured to obtain an AC signal that comprises an odd harmonic of an operating frequency of a system coupled with the BESS, inject the AC signal into a node of the battery set, estimate an AC impedance of the battery set based on a response of the battery set to the injected AC signal. The third aspect of the disclosure may seek to solve a similar problem as the first aspect of the disclosure or the second aspect of the disclosure, or both, in a system suitable for operation with alternative energy systems, such as a solar energy installation, and in a system suitable for injection of desired harmonics. A technical benefit may include determining battery characteristics or parameters with a higher level of accuracy than other (e.g., exclusively DC-based impedance estimation) methods, devices, or systems and in a manner that is usable with various types of sensors without disrupting BESS operations and that may be integrated with utility applications.

Optionally in some examples, including in at least one preferred example, the BESS may be configured to inject an AC signal that comprises a third harmonic of the operating frequency of the system coupled with the BESS. A technical benefit may include creating a response signal that provides an accurate and faster response (e.g., relative to measuring a DC response) indicative of battery internal impedance.

Optionally in some examples, including in at least one preferred example, the BESS may be configured to estimate a DC impedance of the battery set, and determine a total estimated impedance based on the estimated AC impedance and the estimated DC impedance. A technical benefit may include a more accurate impedance estimation than relying on either an AC response or a DC response.

Optionally in some examples, including one or more preferred examples, the BES may be configured to implement any of the examples of the method of the first aspect of the disclosure or the electronic device of the second aspect of the disclosure, or both, providing the same or similar technical benefits.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 1** is a block diagram of an exemplary battery energy storage system (BESS) according to an example.
**FIG. 2** is a flow chart of exemplary method according to one or more examples.
**FIG. 3** is a block diagram of an exemplary electronic device according to an example.

### DETAILED DESCRIPTION

The detailed description set forth below provides information and examples of the disclosed technology with sufficient detail to enable those skilled in the art to practice the disclosure.

The internal impedance of a battery or set of batteries may be determined by measuring a response from an AC signal injected into the battery or battery set. The internal impedance of a battery may provide an indication of, or may be a basis from which to determine, characteristics of the battery. The impedance of the battery may, for example, determine or indicate one or more of the power capability of the battery, the irreversible Joule losses of the battery, or an indication of the state of charge (SoC) of the battery. The health of a battery and thus its usefulness may be determined from such characteristics. The battery may also be managed, such as charged or discharged, based on such characteristics. Thus, measuring and accurately identifying such characteristics may be important or useful for operating of a BESS, or other systems, associated with the battery.

By way of example, SoC can be estimated from the open circuit voltage of a battery when the battery is at rest. This may be an appropriate or preferred technique for some Lithium-ion battery chemistries, such as a Lithium Nickel Manganese Cobalt Oxide (NMC). Such open circuit testing may be combined with other techniques, such as Coulomb counting when the battery is not at rest, to characterize the SoC. By contrast, Lithium Iron Phosphate (LFP) batteries, or cells may have a relatively flat open circuit voltage curve (e.g., a plot of open circuit voltage versus SoC), which may create challenges or inaccuracies in using open circuit voltage to measure SoC for LFP batteries. Accordingly, some LFP operations or deployments may, as a matter of course, fully charge LFP batteries at certain intervals (e.g., weekly or daily) without attempting to tailor charging for the actual SoC. Such operation may result in excessive or unnecessary charging or cycling of an LFP battery that could be avoided with more accurate determination of battery characteristics.

Determining or measuring internal impedance of a battery, such as an LFP battery, may allow for determination of such battery characteristics. Internal impedance may be determined from a DC response (e.g., a response to a DC signal injected into the battery), but the DC response may be unreliable because the response signal may increase relatively slowly (e.g., a plot of the measured impedance verses time elapsed from signal injection may increase gradually) and may thus provide inaccurate results if the response signal is measured too early. Further, sensors employed in or with a BESS for measuring such a response may have insufficient accuracy ratings to reliably measure the impedance based on a DC response.

Accordingly, methods, devices, and systems as described herein that employ an AC signal and determine an internal battery impedance from the AC signal, either alone or in combination with a DC response, may support accurate battery characterization for various battery chemistries.

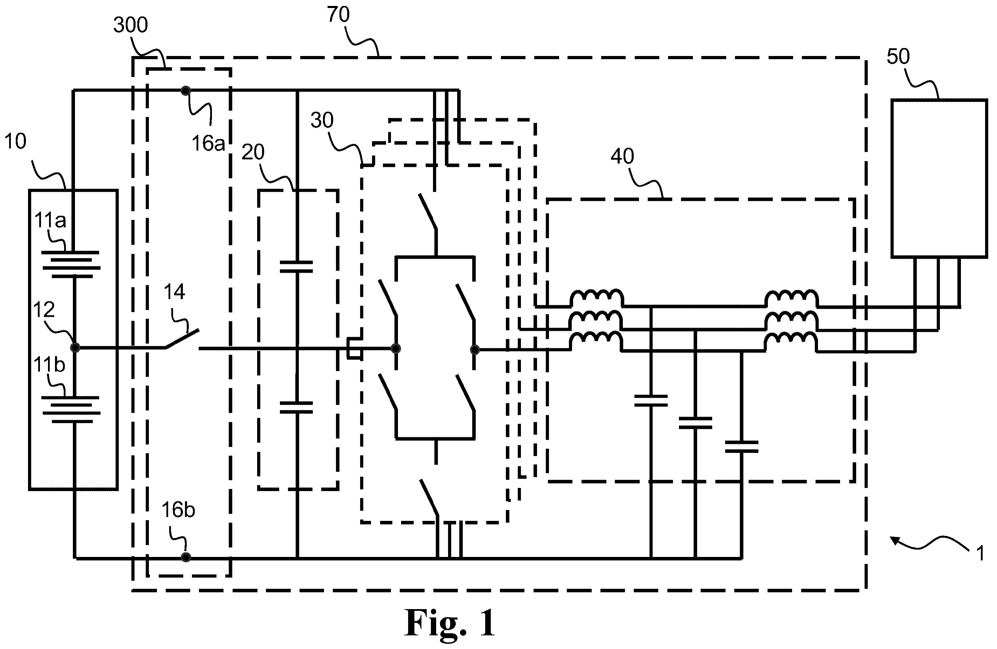

**FIG. 1** is a block diagram of an exemplary BESS 1 according to an example. The BESS 1 may include or be coupled with a battery set 10, which may comprise a first battery 11a connected in series with a second battery 11b via a node 12. The BESS 1 may include a Neutral Point Clamped (NPC) inverter 70 coupled with the battery set 10 via the node 12. The NPC inverter may include various capacitors 20, switches 30, and filters 40 recognizable and understood by those skilled in the art.

In some examples, BESS 1 includes electronic device 300, which may be or may include, and may be referred to as, circuitry, configured to obtain an AC signal that comprises an odd harmonic of an operating frequency of a system 50 coupled with the BESS 1. As used herein, AC may be understood as alternating current and DC may be understood as direct current. System 50 may be an electric utility grid in some examples. The term obtain or obtaining may be understood as generating, creating, or receiving, or any combination thereof, according to different examples. For instance, electronic device 300 may be integrated with BESS 1, which may generate or create an AC signal as described herein. In some examples, electronic device 300 may include or may be circuitry that filters or smooths an AC signal received from NPC inverter 70; electronic device 300 may thus receive or create, or both, an AC signal. For instance, electronic device 300 may be a discrete component or device coupled with NPC inverter 70 via terminals 16a, 16b. In some examples, the NPC inverter 70 comprises the circuitry of electronic device 300.

As used herein, a harmonic is an AC signal (e.g., an electric current having or represented by an AC waveform) with a frequency that is an integer multiple of a fundamental frequency, such as the operating frequency of system 50. Odd harmonics occur at or are understood as odd multiples of the fundamental frequency, such as the third harmonic, fifth harmonic, seventh harmonic, and so on. The third harmonic of a 50 Hertz fundamental or operating frequency is 150 Hertz; the third harmonic of a 60 Hertz fundamental or operating frequency is 180 Hertz. The operating frequency of the system 50 as disclosed herein can be seen as a frequency at which system 50 operates. In some examples, system 50 has an operating frequency of 50 Hertz or 60 Hertz, and the third harmonic of the AC signal obtained (such as created or generated) by BESS 1 and/or electronic device 300 is 150 Hertz or 180 Hertz.

NPC inverter 70 may be configured to create or generate an AC signal (e.g., an AC waveform) using switches 30 from a DC signal, which itself was created by BESS 1 by rectifying a signal from system 50. NPC inverter 70 may be an I-Type inverter, for example. Switches 30 may include IGBT and/or MOSFETS. NPC inverter 70 may employ Pulse Width Modulation (PWM) to create an AC signal and to charge or discharge, or both, the battery set 10. PWM may be understood as a technique for creating a non-sinusoidal wave form, which may be smoothed, for example, using capacitors 20 or other appropriate filters.

BESS 1, for example via electronic device 300, may be configured to inject the AC signal into a node 12 of the battery set 10. The AC signal may comprise a third harmonic of the operating frequency of the system 50 coupled with the BESS 1. The BESS 1, for example via NPC inverter 70, may be coupled with the battery set 10 via a switch 14, and the AC signal may be injected via switch 14, which, for example, may be a feature of and/or controlled by electronic device 300. Switch 14 may thus allow electronic device 300 or other features of NPC inverter 70 to be disconnected from battery set 10.

BESS 1, for example via electronic device 300, may be configured to estimate an AC impedance of the battery set based on a response of the battery set to the injected AC signal. AC impedance, as used herein, is understood to be the internal impedance of battery set 10 measured, observed, or determined, based on the response of battery set 10 to the AC signal being injected. In some examples, BESS 1, for example via electronic device 300, may be configured to measure the response of the battery set 10 at least 100 milliseconds after injecting the AC signal, and estimate the AC impedance of the battery set 10 based on the response of the battery set 10 measured at least 100 milliseconds after injecting the AC signal. Measuring such a response after 100 milliseconds may allow the responsive signal to settle to a steady state and may thus increase the accuracy and/or reliability of such a measurement. The estimated AC impedance may be a function of the frequency of the injected AC signal.

In some examples, BESS 1, such as via electronic device 300, may be, additionally or alternatively, configured to estimate a DC impedance of the battery set 10. DC impedance, as used herein, is understood to be the internal impedance of battery set 10 measured, observed, or determined based on the response of battery set 10 to a DC signal being injected from BESS 1, for example via electronic device 300 and/or NPC inverter 70. In some examples, BESS 1, for example via electronic device 300, may be configured to determine a total estimated impedance of battery set 10 based on the estimated AC impedance and the estimated DC impedance. As used herein, total estimated impedance can be seen as the impedance determined from a combination of the battery set 10 responses to an injected AC signal and to an injected DC signal.

Measuring or observing a response or value, as used herein, may be understood as determining a value using any of various accepted techniques, calculations, or instrumentation. It may include measuring, for example, voltage and/or current at or through a given point(s), such as terminal 16a and/or 16b and calculating an impedance accordingly. Such calculation may be done by processing circuitry embedded in electronic device 300 or another component of BESS 1.

In some examples, BESS 1, for example via electronic device 300, may be configured to perform a galvanostatic impedance estimation, estimate the AC impedance based on the estimated galvanostatic impedance. Galvanostatic may be understood as a process of charging or discharging, or both, a battery 11a, 11b (or battery set 10) at a constant current rate without regard to voltage changes or fluctuations. Such controlled charging and discharging may allow for, or accommodate, changes in voltage resulting from an SoC of battery 11a, 11b and/or battery set 10.

In some examples, BESS 1, for example via electronic device 300, may be configured to determine, such as based on the AC impedance or the total estimated impedance, or both, a characteristic of the battery set 10. The characteristic may comprise at least one of a state of charge (SoC), battery temperature, or power capability, or any combination thereof. The characteristic or characteristics may be determined via, for example processing circuity of electronic device 300 or BESS 1. For example, electronic device 300 may be configured with, such as in memory circuitry of electronic device 300, data representative of battery characteristics. For example, characteristics may be defined as functions of internal impedance represented as data, e.g., stored in electronic device 300. Thus, by determining a given impedance value, such as by determining real and/or imaginary components of a complex number representative of the impedance, electronic device 300 may determine one or more characteristics of battery set 10.

In some examples, various characteristics of battery set 10 may be plotted as a function of real and/or imaginary components of various impedance values, and such plots or functions may be stored as or otherwise converted to data for use in processing and related calculations by electronic device 300. Such functions my also vary by or be dependent on frequency, which may be accounted for by electronic device 300. Thus, a measured or observed AC impedance of battery set 10 at 180 Hertz, for example, may be used to determine an SoC for battery set 10; combining a measured or observed DC impedance of battery set 10 may support a more refined, accurate, and/or reliable result.

In some examples, BESS 1, for example via electronic device 300, may be configured to estimate an impedance for the first battery 11a or the second battery 11b, or both. Such estimation may be done separately for either or both batteries 11a, 11b. This may allow BESS 1 to identify issues at a more granular level, which may support management, changes, and/or maintenance with more specificity than monitoring the battery set 10 as a single unit.

In some examples, the first battery 11a and the second battery 11b have a same nominal voltage rating. Thus, batteries of the battery set 10 may be changed out individually and readily. For example, battery set 10 may have a nominal voltage of 1500 VDC and batteries 11a, 11b may each have a nominal voltage of 750 VDC. Because the battery set 10 may be composed of smaller units (e.g., multiple batteries connected in series to give rise to the total desired voltage), each may be relatively smaller, less complex, less expensive, or the like, it may support a more economic or scalable basis for management. Accordingly, determining characteristics of individual batteries 11a, 11b, within the battery set 10 may support such management.

The system of FIG. 1 has been described primarily in the context of a BESS. The skilled person will recognize, however, that features and solutions described herein may apply to other systems, such as electric drives.

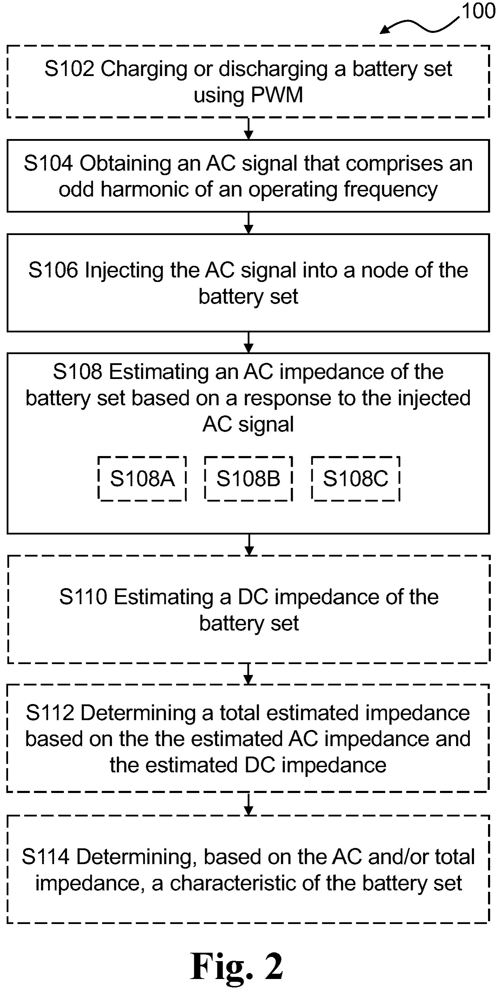

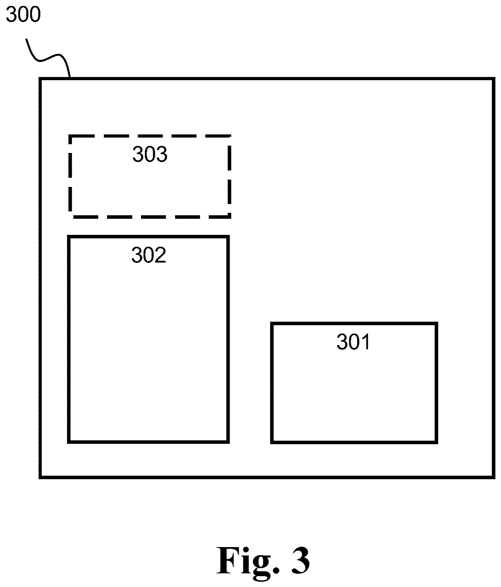

**FIG. 2** is a flow chart of an exemplary method 100 according to one or more examples. Method 100 may be performed by a BESS or components of a BESS, such as features of BESS 1 or electronic device 300 described with reference to FIG. 1 and/or FIG. 3.

In one or more examples, the method 00 comprises charging and/or discharging S102 a battery set using PWM. The AC signal may be generated based on the PWM. The BESS may comprise an NPC inverter. The BESS, such as via the NPC inverter, may be coupled with a node of the battery set via a switch. Each battery of the battery set may have a same nominal voltage rating.

The method 100 comprises obtaining S104 an AC signal that comprises an odd harmonic of an operating frequency of a system coupled with the BESS. Obtaining S104 the AC signal for example comprises generating, creating, retrieving, and/or receiving the AC signal that comprises an odd harmonic of an operating frequency of a system coupled with the BESS. The AC signal may comprise a third harmonic of the operating frequency of the system coupled with the BESS. The operating frequency of the system coupled with the BESS may comprise 50 Hertz or 60 Hertz. The system coupled with the BESS may comprise an electric utility grid.

The method 100 comprises injecting S106 the AC signal into a node of the battery set. The battery set, for example comprises, one or more batteries. The battery set may comprise a first battery connected in series with a second battery via the node. In some examples, the battery set comprises a first battery, a second battery, a third battery, a fourth battery, etc., which are for example connected via one or more nodes.

The method 100 comprises estimating S108 an AC impedance of the battery set based on a response of the battery set to the injected AC signal. In one or more example methods, the method 100 comprises measuring S108A the response of the battery set at least 100 milliseconds after injecting the AC signal. In one or more example methods, the method 100 comprises estimating S108B an impedance for each of one or more batteries of the battery set. In one or more example methods, the method 100 comprises estimating S108C the AC impedance comprises performing a galvanostatic impedance estimation.

In one or more example methods, the method 100 comprises estimating S110 a DC impedance of the battery set.

In one or more example methods, the method 100 comprises determining S112 a total estimated impedance based on the estimated AC impedance and the estimated DC impedance.

In one or more example methods, the method 100 comprises determining S114, such as based on the AC impedance or the total estimated impedance, or both, a characteristic of the battery set, the characteristic comprising at least one of a state of charge (SoC), battery temperature, or power capability, or any combination thereof. SoC may be seen as current charge, amount of charge, or the stored energy (e.g., expressed as a percentage or measured in Amp-hours or Joules) of a battery. Power capability may be seen as the power (e.g., measured in Watts), which may be limited by the thermal cooling capacity of a battery with respect to the internal impedance, a battery is capable of outputting.

**FIG. 3** is a block diagram of an exemplary electronic device 300 according to an example. The electronic device 300 may be an example of electronic device 300 described with reference to FIG. 1. Electronic device 300 comprises memory circuitry 301 and processing circuity 302. Electronic device 303 may comprise interface 303, which may be an interface with a BESS, such as BESS 1 described with reference to FIG. 1, or may be or support a user interface to facilitate management of electronic device 300.

Electronic device 300 is configured to obtain an AC signal that comprises an odd harmonic of an operating frequency of a system coupled with the BESS. The AC signal may comprise a third harmonic of the operating frequency of the system coupled with the BESS. The operating frequency of the system coupled with the BESS may comprise 50 Hertz or 60 Hertz. The system coupled with the BESS may comprise an electric utility grid. The BESS may comprise an NPC inverter. The NPC inverter may charge or discharge, or both, the battery set using PWM, and it may generate the AC signal based on the PWM. Electronic device 300 may, for example, be configured to control or manage aspects of the NPC inverter, such as NPC inverter 70 described with reference to FIG. 1, to create the AC signal.

Electronic device 300 is configured to inject the AC signal into a node of the battery set. The battery set may comprise a first battery connected in series with a second battery via the node. Electronic device 300 may, for example, control or manage aspects of an NPC inverter, such as NPC inverter 70 described with reference to FIG. 1, to inject the AC signal. The BESS, or an NPC inverter, may be coupled with the node of the battery set via a switch, which electronic device 300 may control.

Electronic device 300 is configured to estimate, such as via processor circuitry 302, an AC impedance of the battery set based on a response of the battery set to the injected AC signal. Electronic device 300 may be configured to measure the response of the battery set at least 100 milliseconds after injecting the AC signal and estimate the AC impedance of the battery set based on the response of the battery set measured at least 100 milliseconds after injecting the AC signal. Electronic device 300 may be configured to perform a galvanostatic impedance estimation and estimate the AC impedance based on the estimated galvanostatic impedance. In some examples, electronic device 300 is configured to estimate an impedance for each of one or more batteries of the battery set. Each battery of the battery set may have a same nominal voltage rating.

Electronic device may, for example, receive via interface 303 signals representative of current or voltage of the response from a battery set. In some examples, electronic device 300 is configured to receive or process information received via an NPC inverter 70. Electronic device 300 may thus be configured to manage or interpret signals, such as relatively high voltage and/or large current signals received by or via NPC inverter 70; and signals received by electronic device 300 may be low voltage signals representative of a response. In other words, electronic device 300 may be configured as an instrument associated with or a component of a BESS but may not receive signals at line or operating voltage from a battery set.

In some examples, electronic device 300 is configured to estimate a DC impedance of the battery set and determine a total estimated impedance based on the estimated AC impedance and the estimated DC impedance. Electronic device may be configured to determine, based on the AC impedance or the total estimated impedance, or both, a characteristic of the battery set, the characteristic comprising at least one of a state of charge, SoC, battery temperature, or power capability, or any combination thereof.

Processing circuitry 302, in some examples, is adapted to execute instructions from a computer-readable medium, such as memory circuitry 301, to perform these and/or any of the functions or processing described herein, including the steps of method 100 described with reference to FIG. 2. The processor circuitry 302 of Fig. 3 is optionally configured to perform any of the operations disclosed in Fig.3 (such as any one or more of: S102, S104, S106, S108, S108A, S108B, S108C, S110, S112, S114). The operations of the electronic device 300 may be embodied in the form of executable logic routines (e.g., lines of code, software programs, etc.) that are stored on a non-transitory computer readable medium (e.g., the memory circuitry 301 of Fig. 3) and are executed by the processor circuitry 302 of Fig. 3).

The electronic device 300 may be connected (e.g., networked) to other machines in a LAN (Local Area Network), an intranet, an extranet, or the Internet. While only a single device is illustrated, the electronic device 300 may include any collection of devices that individually or jointly execute a set (or multiple sets) of instructions to perform any one or more of the methodologies discussed herein. Accordingly, any reference in the disclosure and/or claims to a processor device, processing circuitry, etc., includes reference to one or more such devices to individually or jointly execute a set (or multiple sets) of instructions to perform any one or more of the methodologies discussed herein. For example, electronic device 300 or BESS 1 described with reference to FIG. 1, may include a single unit or a plurality of units connected or otherwise communicatively coupled to each other, such that any performed function may be distributed between the units as desired.

The electronic device 300 may comprise at least one computing device, such as processing circuitry 302, capable of including firmware, hardware, and/or executing software instructions to implement the functionality described herein. The processing circuitry 302 is coupled with memory circuitry 301 via one or more busses and/or interfaces. The processing circuitry 302 may include any number of hardware components for conducting data or signal processing or for executing computer code stored in memory circuitry 301. The processing circuitry 302 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 302 may further include computer executable code that controls operation of the programmable device.

The bus between processor circuitry 302 and memory circuitry 301 may be any of several types of bus structures that may further interconnect to a memory bus (with or without a memory controller), a peripheral bus, and/or a local bus using any of a variety of bus architectures. The memory circuitry 301 may be one or more devices for storing data and/or computer code for completing or facilitating methods described herein. The memory circuitry 301 may include database components, object code components, script components, or other types of information structure for supporting the various activities herein. Any distributed or local memory device may be utilized with the systems and methods of this description. The memory circuitry 301 may be communicably connected to the processing circuitry 302 (e.g., via a circuit or any other wired, wireless, or network connection) and may include computer code for executing one or more processes described herein. The memory circuitry 301 may include non-volatile memory (e.g., read-only memory (ROM), erasable programmable read-only memory (EPROM), electrically erasable programmable read-only memory (EEPROM), etc.), and volatile memory (e.g., random-access memory (RAM)), or any other medium which can be used to carry or store desired program code in the form of machine-executable instructions or data structures and which can be accessed by a computer or other machine with processing circuitry 302.

Interface 303 may be configured to receive input and selections to be communicated to the electronic device 300 when executing instructions, such as from an NPC inverter or another component of a BESS, a keyboard, mouse, touch-sensitive surface, etc. Such input devices may be connected to the processing circuitry 302 through the interface 303 coupled to other interfaces, such as a parallel port, an Institute of Electrical and Electronic Engineers (IEEE) 1394 serial port, a Universal Serial Bus (USB) port, an IR interface, and the like. The interface 303 may be configured to forward output, such as to a display, a video display unit. The interface 303 may be suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Various example methods, devices, and systems are set forth in the following.

Example 1: A method for estimating impedance of a battery set (10) associated with a battery energy storage system (BESS) the method comprising:
- obtaining an AC signal that comprises an odd harmonic of an operating frequency of a system coupled with the BESS;
- injecting the AC signal into a node of the battery set; and
- estimating an AC impedance of the battery set based on a response of the battery set to the injected AC signal.

Example 2: The method of example 1, wherein the AC signal comprises a third harmonic of the operating frequency of the system coupled with the BESS.

Example 3: The method of any of examples 1-2, wherein the battery set comprises a first battery connected in series with a second battery via the node.

Example 4: The method of any of examples 1-3, wherein the BESS is coupled with the node of the battery set via a switch.

Example 5: The method of any of examples 1-4, further comprising:
- estimating a DC impedance of the battery set; and
- determining a total estimated impedance based on the estimated AC impedance and the estimated DC impedance.

Example 6: The method of any of examples 1-5, further comprising determining, based on the AC impedance or the total estimated impedance, or both, a characteristic of the battery set, the characteristic comprising at least one of a state of charge, SoC, battery temperature, or power capability, or any combination thereof.

Example 7: The method of any of examples 1-6, wherein the system coupled with the BESS comprises an electric utility grid.

Example 8: The method of any of examples, 1-7 wherein the operating frequency of the system coupled with the BESS comprises 50 Hertz or 60 Hertz.

Example 9: The method of any of examples 1-8, wherein estimating the AC impedance of the battery set comprises measuring the response of the battery set at least 100 milliseconds after injecting the AC signal.

Example 10: The method of any of examples 1-9, wherein the BESS comprises a Neutral Point Clamped (NPC) inverter.

Example 11: The method of any of examples 1-10, comprising charging or discharging, or both, the battery set using pulse width modulation (PWM) wherein the AC signal is generated based on the PWM.

Example 12: The method of any of examples 1-11, wherein estimating the AC impedance of the battery set comprises estimating an impedance for each of one or more batteries of the battery set.

Example 13: The method of any of examples 1-12, wherein each battery of the battery set has a same nominal voltage rating.

Example 14: The method of any of examples 1-13, wherein estimating the AC impedance comprises performing a galvanostatic impedance estimation.

Example 15: An electronic device operable with a battery energy storage system, BESS, the electronic device comprising processing circuitry and memory circuitry, the electronic device configured to:
- obtain an AC signal that comprises an odd harmonic of an operating frequency of a system coupled with the BESS;
- inject the AC signal into a node (12) of the battery set; and
- estimate an AC impedance of the battery set based on a response of the battery set to the injected AC signal.

Example 16: The electronic device of example 15, wherein the AC signal comprises a third harmonic of the operating frequency of the system coupled with the BESS.

Example 17: The electronic device of any of examples 15-16, wherein the battery set comprises a first battery connected in series with a second battery via the node.

Example 18: The electronic device of any of examples 15-17, wherein the BESS is coupled with the node of the battery set via a switch.

Example 19: The electronic device of any of examples 15-18, further configured to:
- estimate a DC impedance of the battery set; and
- determine a total estimated impedance based on the estimated AC impedance and the estimated DC impedance.

Example 20. The electronic device of any of examples 15-19, further configured to determine, based on the AC impedance or the total estimated impedance, or both, a characteristic of the battery set, the characteristic comprising at least one of a state of charge, SoC, battery temperature, or power capability, or any combination thereof.

Example 21: The electronic device of any of examples 15-20, wherein the system coupled with the BESS comprises an electric utility grid.

Example 22: The electronic device of any of examples 15-21, wherein the operating frequency of the system coupled with the BESS comprises 50 Hertz or 60 Hertz.

Example 23: The electronic device of any of examples 15-22, further configured to:
- measure the response of the battery set at least 100 milliseconds after injecting the AC signal; and
- estimate the AC impedance of the battery set based on the response of the battery set measured at least 100 milliseconds after injecting the AC signal.

Example 24: The electronic device of any of examples 15-23, wherein the BESS comprises a Neutral Point Clamped (NPC) inverter.

Example 25: The electronic device of any of examples 15-24, further configured to:
- charge or discharge, or both, the battery set using pulse width modulation (PWM); and
- generate the AC signal based on the PWM.

Example 26: The electronic device of any of examples 15-25, further configured to estimate an impedance for each of one or more batteries of the battery set.

Example 27: The electronic device of any of examples 15-26, wherein each battery of the battery set has a same nominal voltage rating.

Example 28: The electronic device of any of examples 15-27, further configured to:
- perform a galvanostatic impedance estimation; and
- estimate the AC impedance based on the estimated galvanostatic impedance.

Example 29: A battery energy storage system, BESS, comprising:
- a battery set comprising first battery connected in series with a second battery via a node;
- a Neutral Point Clamped (NPC) inverter coupled with the battery set via the node; and
- circuitry configured to:
   obtain an AC signal that comprises an odd harmonic of an operating frequency of a system coupled with the BESS;
   inject the AC signal into a node of the battery set; and
   estimate an AC impedance of the battery set based on a response of the battery set to the injected AC signal.

Example 30: The BESS of example 29, wherein the AC signal comprises a third harmonic of the operating frequency of the system coupled with the BESS.

Example 31: The BESS of any of examples 29-30, further comprising a switch, wherein the NPC is coupled with the battery set via the switch.

Example 32: The BESS of any of examples 29-31, wherein the circuitry is configured to:
- estimate a DC impedance of the battery set; and
- determine a total estimated impedance based on the estimated AC impedance and the estimated DC impedance.

Example 33: The BESS of any of examples 29-32, wherein the circuitry is configured to determine, based on the AC impedance or the total estimated impedance, or both, a characteristic of the battery set, the characteristic comprising at least one of a state of charge, SoC, battery temperature, or power capability, or any combination thereof.

Example 34: The BESS of any of examples 29-33, wherein the system coupled with the BESS comprises an electric utility grid.

Example 35: The BESS of any of examples 29-34, wherein the operating frequency of the system coupled with the BESS comprises 50 Hertz or 60 Hertz.

Example 36: The BESS of any of examples 29-35, wherein the circuitry is configured to:
- measure the response of the battery set at least 100 milliseconds after injecting the AC signal; and
- estimate the AC impedance of the battery set based on the response of the battery set measured at least 100 milliseconds after injecting the AC signal.

Example 37: The BESS of any of examples 29-36, wherein the NPC invertor is configured to charge or discharge, or both, the battery set using pulse width modulation (PWM) and wherein the circuitry is configured to generate the AC signal based on the PWM.

Example 38: The BESS of any of examples 29-37, wherein the circuitry is configured to estimate an impedance for the first battery or the second battery, or both.

Example 39: The BESS of any of examples 29-38, wherein the first battery and the second battery have a same nominal voltage rating.

Example 40: The BESS of any of examples 29-39, wherein the circuitry is configured to:
- perform a galvanostatic impedance estimation; and
- estimate the AC impedance based on the estimated galvanostatic impedance.

Example 41: The BESS of any of examples 29-40, wherein the NPC inverter comprises the circuitry.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A method for estimating impedance of a battery set associated with a battery energy storage system, BESS, the method comprising:
- obtaining an AC signal that comprises an odd harmonic of an operating frequency of a system coupled with the BESS;
- injecting the AC signal into a node of the battery set; and
- estimating an AC impedance of the battery set based on a response of the battery set to the injected AC signal.

2. The method according to claim 1, wherein the AC signal comprises a third harmonic of the operating frequency of the system coupled with the BESS.

3. The method according to any of claims 1-2, further comprising:
- estimating a DC impedance of the battery set; and
- determining a total estimated impedance based on the estimated AC impedance and the estimated DC impedance.

4. The method according to any of claims 1-3, further comprising determining, based on the AC impedance or the total estimated impedance, or both, a characteristic of the battery set, the characteristic comprising at least one of a state of charge, SoC, battery temperature, or power capability, or any combination thereof.

5. The method according to any of claims 1-4, wherein the operating frequency of the system coupled with the BESS comprises 50 Hertz or 60 Hertz.

6. The method according to any of claims 1-5, wherein estimating the AC impedance of the battery set comprises measuring the response of the battery set at least 100 milliseconds after injecting the AC signal.

7. The method according to any of claims 1-6, comprising charging or discharging, or both, the battery set using pulse width modulation, PWM, wherein the AC signal is generated based on the PWM.

8. The method according to any of claims 1-7, wherein estimating the AC impedance of the battery set comprises estimating an impedance for each of one or more batteries of the battery set.

9. The method according to any of claims 1-8, wherein estimating the AC impedance comprises performing a galvanostatic impedance estimation.

10. An electronic device operable with a battery energy storage system, BESS, the electronic device comprising processing circuitry and memory circuitry, the electronic device configured to:
- obtain an AC signal that comprises an odd harmonic of an operating frequency of a system coupled with the BESS;
- inject the AC signal into a node of the battery set; and
- estimate an AC impedance of the battery set based on a response of the battery set to the injected AC signal.

11. The electronic device according to claim 10, wherein the AC signal comprises a third harmonic of the operating frequency of the system coupled with the BESS.

12. The electronic device according to any of claims 10-11, further configured to:
- estimate a DC impedance of the battery set; and
- determine a total estimated impedance based on the estimated AC impedance and the estimated DC impedance.

13. The electronic device according to any of claims 10-12, further configured to determine, based on the AC impedance or the total estimated impedance, or both, a characteristic of the battery set, the characteristic comprising at least one of a state of charge, SoC, battery temperature, or power capability, or any combination thereof.

14. The electronic device according to any of claims 10-13, wherein the operating frequency of the system coupled with the BESS comprises 50 Hertz or 60 Hertz.

15. The electronic device according to any of claims 10-14, further configured to:
- measure the response of the battery set at least 100 milliseconds after injecting the AC signal; and
- estimate the AC impedance of the battery set based on the response of the battery set measured at least 100 milliseconds after injecting the AC signal.

16. The electronic device according to any of claims 10-15, further configured to estimate an impedance for each of one or more batteries of the battery set.

17. The electronic device according to any of claims 10-16, further configured to:
- perform a galvanostatic impedance estimation; and
- estimate the AC impedance based on the estimated galvanostatic impedance.

18. A battery energy storage system, BESS, comprising:
- a battery set comprising first battery connected in series with a second battery via a node;
- a Neutral Point Clamped, NPC, inverter coupled with the battery set via the node; and
- circuitry configured to:
obtain an AC signal that comprises an odd harmonic of an operating frequency of a system coupled with the BESS;
inject the AC signal into a node of the battery set; and
estimate an AC impedance of the battery set based on a response of the battery set to the injected AC signal.

19. The BESS according to claim 18, wherein the AC signal comprises a third harmonic of the operating frequency of the system coupled with the BESS.

20. The BESS according to any of claims 18-19, wherein the circuitry is configured to:
- estimate a DC impedance of the battery set; and
- determine a total estimated impedance based on the estimated AC impedance and the estimated DC impedance.
